# EUROPEAN PATENT APPLICATION

(11) **EP 3 429 322 A1**
(43) Date of publication of application: **16.01.2019**
(21) Application number: 18181967.3
(22) Date of filing: 05.07.2018
(51) Int. Cl.: H05K 1/18, H05K 3/12

(54) **A METHOD FOR PRODUCING SUPPORT STRUCTURES FOR LIGHTING DEVICES AND CORRESPONDING DEVICE**

(30) Priority: 11.07.2017 IT 201700078083
(71) Applicant: OSRAM GmbH, 80807 München (DE); OSRAM S.P.A. - SOCIETA' RIUNITE OSRAM EDISON CLERICI, 20126 Milano (IT)
(72) Inventor: BALDO, Mr. Lorenzo, I-31040 Giavera del Montello (Treviso) (IT); GRIFFONI, Alessio, I-30030 Fossò (Venezia) (IT); RIEGER, Mr. Thomas, D-93089 Aufhausen (DE)
(74) Representative: Marchitelli, Mauro

(57) **Abstract**

A method for forming support structures (10) for electrically-powered lighting devices, the method comprising:
- providing an electrically insulating ribbon-like substrate (12),
- forming electrically-conductive lines (14) on a surface of the substrate (12) by screen printing of electrically-conductive ink, the screen printing comprising printing a plurality of repeated printed images (16), which follow one another along a longitudinal direction and are separated from each other by separation gaps (G), and
- forming electrically-conductive ink jumpers (18) that extend through said separation gaps (G) and which provide electrical continuity between electrically-conductive lines (14) of adjacent printed images (16), wherein forming ink jumpers (18) comprises delivering electrically-conductive ink by inkjet printing.

## Description

### Field of the invention

The description refers to lighting devices.

One or more embodiments may refer to lighting devices using electrically-powered light radiation sources, for example solid-state light radiation sources such as LED sources.

### Technological background

In the lighting sector, there is a growing demand for lighting modules, e.g. LEDs, with characteristics of adaptability to the requirements of application and use (so-called "customization") with reduced development and implementation times.

Satisfying requirements of this nature is particularly demanding in relation to elongated and flexible LED modules (e.g. ribbon-like) that can be produced in the form of structures of a certain length with a particularly high number of electrical units arranged along the module (for example, connected in parallel with each other) and comprising one or more LED chains and the relative driving circuits.

To facilitate the achievement of electrical continuity and uniform functionality over the entire length of the module, it is possible to apply e.g. two or more buses of a certain length.

To facilitate the use of these modules, it is desirable that the user is able to cut the module lengthwise in any position between two adjacent electrical units, so as to be able to have a solution that is adaptable to the requirements of application and use.

From the implementation point of view, it is also desirable that these modules can be produced with reel-to-reel (R2R) methods so as to have modules of a certain length with continuity characteristics with contained costs.

To satisfy this need it is possible to use flexible structures that are laminated ("clad") on one side or on two sides with conductive materials such as copper or aluminum and to etch the conductive layers according to the required configuration (layout) of electric lines.

In the case of a change in the layout, this solution requires an almost complete review of the entire printed circuit board, e.g. Flexible Printed Circuit Board - FPCB, with an intervention designed to involve the board manufacturer as well. All this translates into an additional activity with the added costs and time associated with it.

Another solution may envisage the use of electrically-conductive inks printed on a substrate with techniques such as rotogravure, flexographic printing or offset printing.

These printing techniques make it possible to produce continuous, electrically-conductive lines with a certain length. However, these are rather thin lines (for example, with a thickness of less than 10 microns (1 micron = 10⁻⁶ m), which results in an increase in electrical resistance, and consequently, in a reduction of the electrical functionality in the case of modules of a certain length.

Also in this case, the electrical layout cannot be customized easily and quickly, as the adaptation to a new layout may involve particularly relevant changes to the processing tools (forms of printing).

Another solution is to use conductive inks printed with rotary printing. This printing technique makes it possible to produce continuous, electrically-conductive lines with a certain length. Also in this case, the electrical configuration or layout cannot, however, be customized quickly, as the adaptation to a new layout may involve relevant changes to the processing tools.

In addition, it should also be taken into account that the electrically-conductive ink formulations that can be used for the printing techniques described above are not many, which constitutes an additional obstacle for the use of these techniques.

Another solution is the printing of electric lines by inkjet printing with conductive inks. This printing technique makes it possible to produce continuous, electrically-conductive lines with a certain length. The layout of electric lines can be easily customized in a short time. However, this printing method is currently limited to the application of thin layers, i.e. a few microns, which results in high production times in cases where it is necessary to produce thick conductive lines.

In the context of use considered here, screen printing with conductive inks proves to be more advantageous with respect to the other printing techniques considered previously. For example, the screen printing may allow the implementation of a new configuration or layout of electrically-conductive lines in a short period of time, and the production and/or procurement of the printing screens can take place rapidly. All this carries the possibility of creating electrically-conductive lines or tracks with a thickness of, for example, between 5 and 50 microns (1 micron = 10⁻⁶ m), capable of conducting high currents with reduced electrical resistance. In addition to this, the range of inks that can be used for screen printing is fairly wide.

However, the use of a screen printing technique in reel-to-reel methods can be difficult since it is necessary to maintain a certain separation distance (offset distance) in the order of a few millimeters between two successive printing images, to take into account manufacturing tolerances and possible smearing of the ink. The offset distance therefore does not allow continuous electric lines (buses) to be made that extend along the entire length of the module.

### Object and summary

One or more embodiments aim to overcome the drawbacks outlined above.

According to one or more embodiments, this object can be achieved by a method having the characteristics referred to in the following claims.

One or more embodiments may also concern a corresponding device.

The claims form an integral part of the technical disclosure provided here in relation to the embodiments.

One or more embodiments allow the production of support structures for lighting devices (for example, in the form of Flexible Printed Circuit Boards or FPCB) using e.g. thick film polymeric inks (Polymer Thick Film - PTF) in which electrically-conductive (nano)particles are dispersed, e.g. based on silver or copper. These inks can be printed with screen printing techniques on flexible films, for example, based on polyimide - PI, polyethylene naphthalate, PEN, polyethyleneimine - PEI, ultra-thin glass, etc.).

In one or more embodiments, an electrical continuity of the electrically-conductive lines (for example, at the bus level) between successive printing areas can be achieved by using electrically-conductive ink jumpers formed by inkjet printing, which extend through separation gaps between adjacent printing images.

One or more embodiments may offer one or more of the following advantages:
- the possibility of managing the production of new products quickly and with contained costs in a customization perspective, e.g. in relation to flexible and linear LED modules, without causing significant drawbacks, for example, in terms of electrical resistance of the interconnections between successive printing images, since the electrically-conductive ink jumpers may have a thickness equal to or even greater than that of the electric lines formed with screen printing,
- the possibility of introducing changes into the basic structure (for example, FPCB and relative layout of the electrically-conductive lines/tracks) at the level of the assembler of the electronic circuits without necessarily involving the supplier of the basic structure,
- the possibility of managing different electrical configurations or layouts on a single basic structure (for example, FPCB), and therefore different electric circuits,
- the possibility of producing flexible and linear LED modules in the context of a reel-to-reel process,
- the possibility of using a screen printing process for the purposes indicated above, and
- the possibility of achieving a high level of flexibility in the implementation of the LED module.

### Brief description of the figures

One or more embodiments will be now described, purely by way of non-limiting example, with reference to the attached figures, wherein:
- Figure 1 exemplifies a screen printing step,
- Figure 2 is a schematic cross-section along the line II-II of Figure 1.
- Figure 3 exemplifies the formation of ink jumpers,
- Figure 4 is an schematic cross-section along the line IV-IV of Figure 3, and
- Figure 5 exemplifies the application of light radiation sources.

It will be appreciated that, for clarity and simplicity of illustration, the various figures may not be reproduced on the same scale.

### Detailed description

In the following description various specific details are illustrated aimed at a thorough understanding of examples of embodiments of the present description. One or more embodiments may be implemented without one or more of the specific details, or with other methods, components, materials, etc. In other cases, known structures, materials or operations are not shown or described in detail to avoid obscuring various aspects of the embodiments. The reference to "an embodiment" in the context of this description indicates that a particular configuration, structure or characteristic described in relation to the embodiment is included in at least one embodiment. Therefore, phrases such as "in an embodiment", possibly present in different places of this description do not necessarily refer to the same embodiment. Moreover, particular configurations, structures or characteristics can be combined in any convenient way in one or more embodiments.

The references used here are only for convenience and do not therefore define the field of protection or the scope of the embodiments.

The figures refer - in general - to the production of lighting devices of the type suitable for use with electrically-powered light radiation sources (for example, solid state light radiation sources, such as LED sources) arranged on a ribbon-like support structure 10, optionally flexible.

For present purposes, such a structure 10 can be considered to have an indefinite length, of which a particular portion or segment is represented in the figures.

One or more embodiments can benefit from the possibility of subdividing the structure 10 by segmenting it or cutting it to length according to the requirements of application and use.

In one or more embodiments, the structure 10 may comprise a ribbon-like substrate 12, for example, of an electrically-insulating material, substantially similar to a substrate for Printed Circuit Boards (PCB) of a flexible type (Flexible PCB or FPCB).

In one or more embodiments, the substrate 12 may comprise materials such as polyimide - PI, polyethylene naphthalate, PEN, polyethyleneimine - PEI, ultra-thin glass.

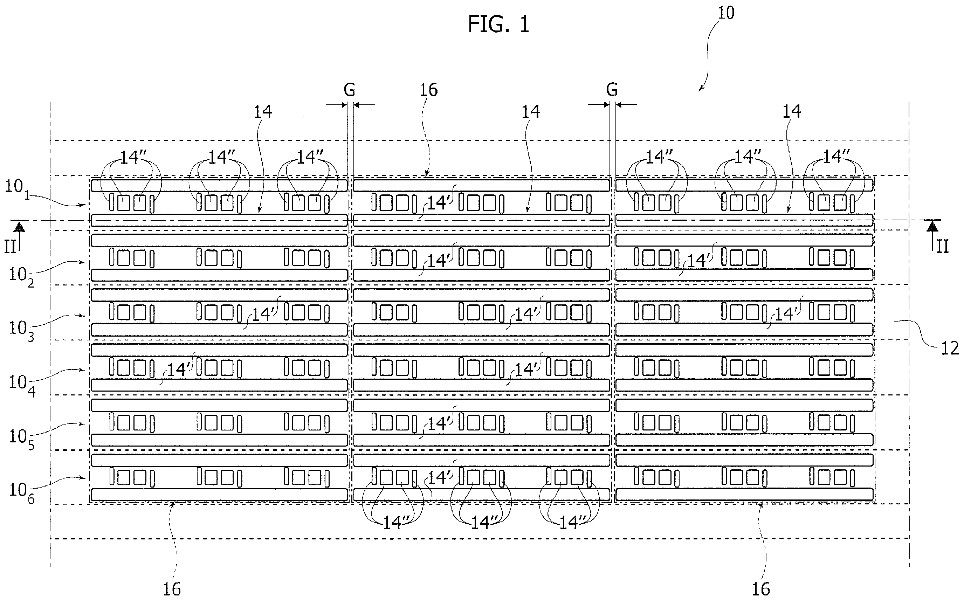

One or more embodiments, as exemplified in Figure 1, envisage carrying out a screen printing operation on the substrate 12, which forms a pattern of electrically-conductive lines 14 on a surface of the substrate 12.

In one or more embodiments, the screen printing may use electrically-conductive ink (for example, polymeric ink for thick film printing - Polymer Thick Film - PTF) containing a dispersion of electrically-conductive material such as, for example, (nano)particles of silver and/or copper.

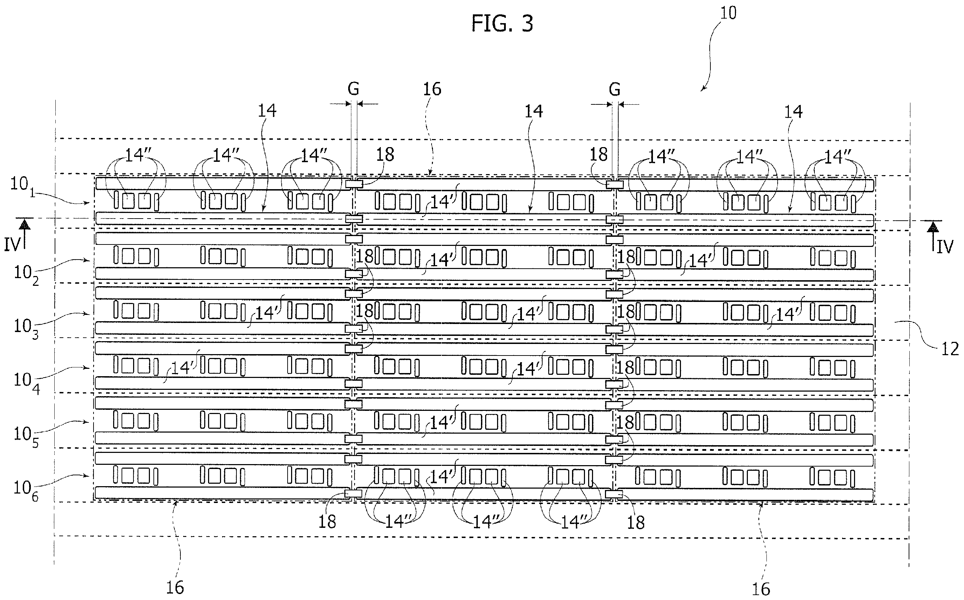

The screen printing forms a series of successive printed images 16, represented in Figures 1, 3 and 5 by respective rectangles with dashed lines, which follow one another in the longitudinal direction of the substrate 12. The printed images 16 may comprise respective electrically-conductive lines 14 arranged according to a predetermined pattern. The successive printed images 16 may follow one another along the longitudinal axis of the substrate 12 with the same repeated pattern.

In one or more embodiments, the electrically-conductive lines 14 may comprise longitudinal lines 14', which can extend continuously over the length of the structure 10 (for example, with a bus function) and connection areas 14" intended to provide an electric conduction function locally in relation to the light radiation sources.

Again, the attached figures refer - purely by way of example, therefore without limiting the scope of the embodiments - to a process aimed at producing, within the ribbon-like structure 10, a certain number of ribbon-like modules 10₁, 10₂, ..., 10₆ (the reference to a number of modules equal to six is merely an example, as these modules can be any number, ideally from 1 to N) initially formed as a single structure and then intended to be separated - operating in a known way - so as to give rise to individual ribbon-like modules usable for producing respective LED modules.

The following part of the present description will, therefore, refer to the structure 10 as a whole, being understood that the operations exemplified with reference to the structure 10 can be carried out with reference to each and every one of the modules 10₁, 10₂, .., 10₆ included therein.

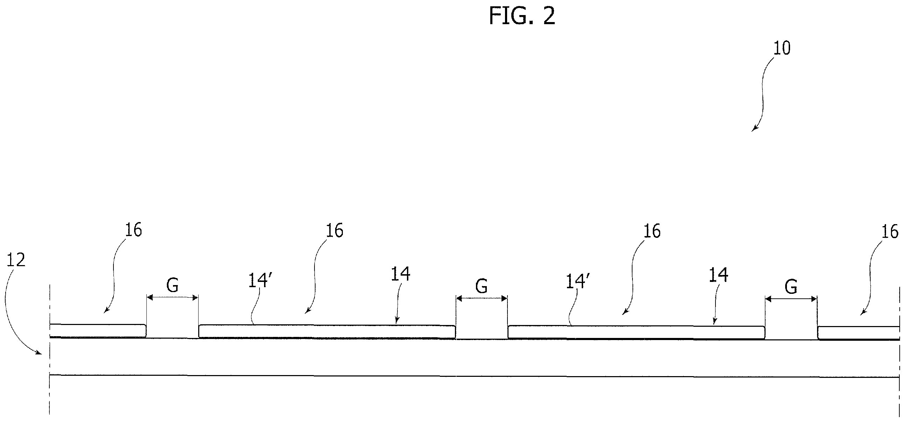

In one or more embodiments, the printed images 16 are spaced apart from each other in the longitudinal direction of the substrate 12 by the separation gaps G. The separation gaps G form an offset distance in the order of a few millimeters between consecutive printing images. The separation gaps G can make it easier to avoid possible problems related to tolerance factors and possible smearing of the electrically-conductive ink during the screen printing process.
As shown in Figure 2, at the end of the screen printing, the electrically-conductive lines 14 of the successive printed images 16 are spaced apart from each other by separation gaps G and are devoid of mutual electrical connections. In one or more embodiments the separation gaps G can be provided between mutually facing ends of bus lines 14' of adjacent printed images 16.

In one or more embodiments, it is possible to provide an electrical continuity between the electrically conductive lines 14 of successive printed images 16. In one or more embodiments, the electrical continuity between the electrically conductive lines 14 of successive printed images 16 can be achieved by forming ink jumpers 18 that extend through the separation gaps G.

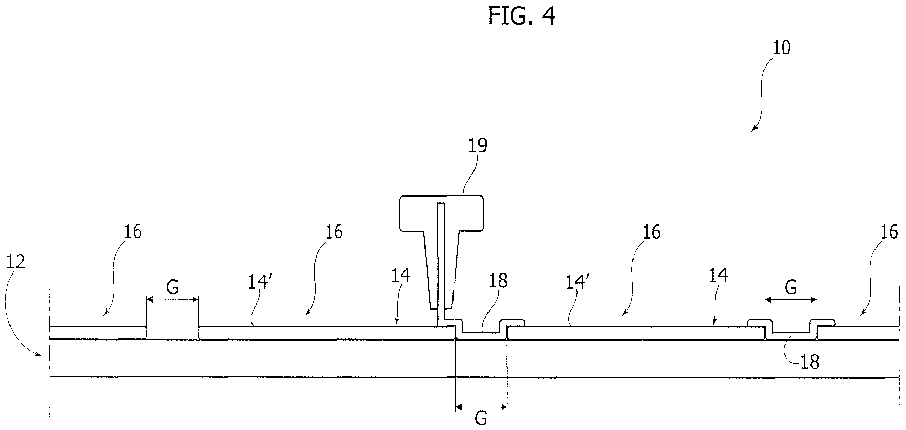

As exemplified in Figure 4, in one or more embodiments the ink jumpers 18 can be formed by delivering electrically-conductive ink by inkjet printing.

In one or more embodiments, the ink jumpers 18 can connect facing ends of respective bus lines 14' of adjacent printed images 16 to each other. The interconnection between the bus lines 14' of two consecutive printed images 16 can be very short, for example, a few millimeters, which results in a short printing time.

In one or more embodiments, the electrically-conductive ink forming the ink jumpers 18 can be dispensed at an inkjet printing station including one or more nozzles 19, located downstream of a screen printing station.

In one or more embodiments, the nozzle 19 is not in contact with the ink applied by means of screen printing, so as to avoid smearing.

In one or more embodiments, the nozzle 10 of the inkjet printing station can deliver the ink forming the ink jumpers 18 onto a three-dimensional surface, for example, on the upper surfaces of the bus lines 14' and on the uncovered support 12, in a single process step.

In one or more embodiments, the inkjet printing that forms the ink jumpers 18 can be carried out prior to the curing of the ink applied by screen printing.

In one or more embodiments, the curing of the ink can be carried out after the screen printing and the formation of the ink jumpers, for example, in an oven unit located downstream of the screen printing station and the inkjet printing station.

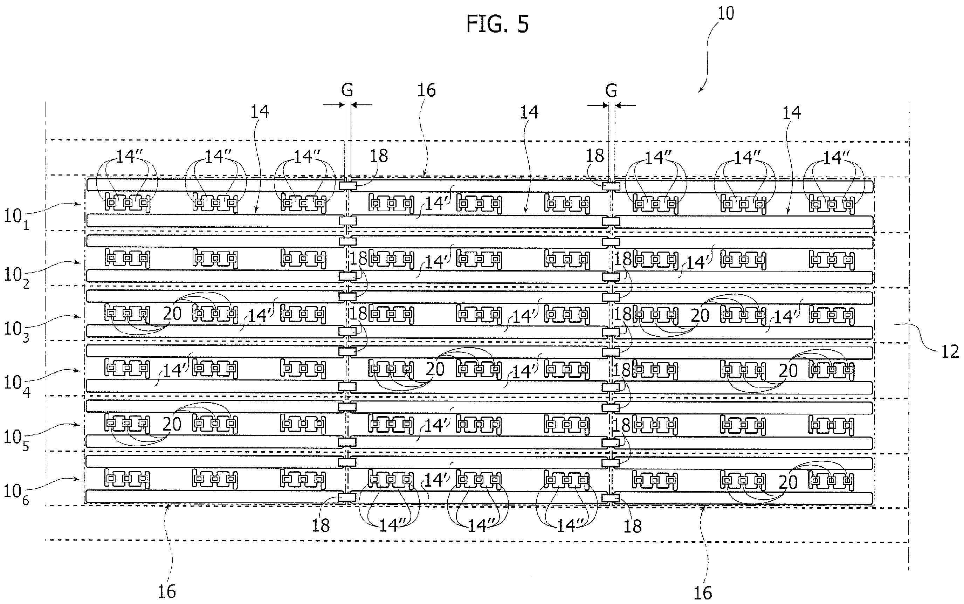

As exemplified in Figure 5, the manufacturing method of the structure 10 may comprise applying electrically-powered light radiation sources 20, e.g. LED sources to said electrically-conductive lines 14 after curing the electrically-conductive ink. In one or more embodiments, the electrically-powered light radiation sources 20 can be mounted on the support structure 10 using known assembly techniques (for example, SMT techniques).

In one or more embodiments, the operations that lead to producing the support structure 10 can be carried out in a reel-to-reel process, which can envisage the continuous unwinding of the substrate 12 from a first reel, and continuously collecting the finished support structure 10 in a second reel at the end of the process.

One or more embodiments may, therefore, provide a method for forming support structures (e.g. 10) for electrically-powered lighting devices, comprising:
- providing an electrically insulating ribbon-like substrate (e.g. 12),
- forming electrically-conductive lines (e.g. 14) on a surface of the substrate (e.g. 12) by screen printing of electrically-conductive ink, the screen printing comprising printing a plurality of repeated printed images (e.g. 16), which follow one another along a longitudinal direction and are separated from each other by separation gaps (e.g. G), and
- forming electrically-conductive ink jumpers (e.g. 18) that extend through said separation gaps (e.g. G) and which provide electrical continuity between electrically-conductive lines (e.g. 14) of adjacent printed images (e.g. 16), wherein forming ink jumpers (e.g. 18) comprises delivering electrically-conductive ink by inkjet printing.

In one or more embodiments, the method may envisage curing said electrically-conductive ink after screen printing and forming said ink jumpers (e.g. 18).

In one or more embodiments, said ink jumpers (e.g. 18) can connect facing ends of respective bus lines 14' of adjacent printed images (e.g. 16) to each other.

In one or more embodiments, delivering electrically-conductive ink by inkjet printing may comprise injecting electrically-conductive ink by means of at least one nozzle (e.g. 19), which is not in contact with the electrically-conductive ink applied by means of screen printing.

In one or more embodiments, the method may comprise applying electrically-powered light radiation sources (e.g. 20) to said electrically-conductive lines (e.g. 14) after curing said electrically-conductive ink.

In one or more embodiments, the method may comprise providing said ribbon-like substrate (e.g. 12) as a reel, and screen printing said electrically-conductive ink onto said ribbon-like substrate (e.g. 12) in a reel-to-reel process.

In one or more embodiments, the method may comprise dividing said support structure (e.g. 10) into a plurality of ribbon-like modules (e.g. 10₁, ....., 10₆) co-extending along the direction of the length of said support structure (e.g. 10).

In one or more embodiments, a lighting device may comprise:
- a support structure (for example, 10) produced according to one or more embodiments, and
- electrically-powered light radiation sources (e.g. 20) arranged on said support structure (e.g. 10) with said light radiation sources (e.g. 20) electrically coupled to said electrically-conductive lines (e.g. 14).

In one or more embodiments:
- said electrically-powered light radiation sources may comprise LED sources (20), and/or
- said electrically-powered light radiation sources (e.g. 20) can be mounted onto said support structure (e.g. 10) with SMT technology.

Without prejudice to the underlying principles of the invention, the details of implementation and the embodiments may vary, even significantly, with respect to those illustrated here, purely by way of non-limiting example, without departing from the scope of the invention.

This field of protection is defined by the attached claims.

**LIST OF REFERENCE SIGNS**

| | |
|---|---|
| support structure | 10 |
| ribbon-like substrate | 12 |
| electrically-conductive lines | 14 |
| printed images | 16 |
| longitudinal lines | 14' |
| connection areas | 14" |
| ribbon-like modules | 10₁, 10₂,..., 10₆ |
| separation gaps | G |
| ink jumpers | 18 |
| nozzles | 19 |
| light radiation sources | 20 |

## Claims

1. A method for forming support structures (10) for electrically-powered lighting devices, the method comprising:
- providing an electrically insulating ribbon-like substrate (12),
- forming electrically-conductive lines (14) on a surface of the substrate (12) by screen printing of electrically-conductive ink, the screen printing comprising printing a plurality of repeated printed images (16), which follow one another along a longitudinal direction and are separated from each other by separation gaps (G), and
- forming electrically-conductive ink jumpers (18) that extend through said separation gaps (G) and which provide electrical continuity between electrically-conductive lines (14) of adjacent printed images (16), wherein forming ink jumpers (18) comprises delivering electrically-conductive ink by inkjet printing.

2. A method according to claim 1, comprising curing said electrically-conductive ink after said screen printing and forming said ink jumpers (18).

3. A method according to any of the preceding claims, wherein said ink jumpers (18) connect facing ends of respective bus lines (14') of adjacent printed images (16) to each other.

4. A method according to any of the preceding claims, wherein delivering electrically-conductive ink by inkjet printing comprises injecting electrically-conductive ink by means of at least one nozzle (19), which is not in contact with the electrically-conductive ink applied by screen printing.

5. A method according to claim 3, comprising applying electrically-powered light radiation sources (20) to said electrically-conductive lines (14) after curing said electrically-conductive ink.

6. A method according to any of the preceding claims, comprising providing said ribbon-like substrate (12) as a reel, and screen printing said electrically-conductive ink on said ribbon-like substrate (12) in a reel-to-reel process.

7. A method according to any of the preceding claims, comprising subdividing said support structure (10) into a plurality of ribbon-like modules (10₁, ..., 10₆) co-extending along the length of said support structure (10).

8. A lighting device, comprising:
- a support structure (10) produced with the method according to any of claims 1 to 7, and
- electrically-powered light radiation sources (20) arranged on said support structure (10) with said light radiation sources (20) electrically coupled to said electrically-conductive lines (14).

9. A lighting device according to claim 8, wherein:
- said electrically-powered light radiation sources include LED sources (20), and/or
- said electrically-powered light radiation sources (20) are mounted onto said support structure (10) with SMT technology.
